# EUROPÄISCHE PATENTSCHRIFT

(11) **EP 1 915 892 B1**
(45) Veröffentlichungstag und Bekanntmachung des Hinweises auf die Patenterteilung: **31.10.2012**
(21) Anmeldenummer: 06754242.3
(22) Anmeldetag: 09.06.2006
(51) Int. Cl.: H05K 7/20, F04D 29/58, F04D 29/60, F04D 29/64, G06F 1/20

(54) **BEFESTIGUNG EINES LÜFTERS FÜR EIN ELEKTRONISCHES GERÄT**
MOUNTING A FAN FOR AN ELECTRONIC DEVICE
FIXATION D'UN VENTILATEUR DESTINE A UN APPAREIL ELECTRONIQUE

(30) Priorität: 19.08.2005 DE 102005039265
(43) Veröffentlichungstag der Anmeldung: 30.04.2008
(73) Patentinhaber: Hirschmann Car Communication GmbH, 72654 Neckartenzlingen (DE)
(72) Erfinder: SILVA, David, 72622 Nürtingen (DE)
(74) Vertreter: Greif, Thomas
(86) Internationale Anmeldenummer: PCT/EP2006/005515
(87) Internationale Veröffentlichungsnummer: WO 2007/019904

(56) Entgegenhaltungen:
- EP-A1- 1 392 095
- DE-A1- 10 101 348
- DE-A1- 19 731 411
- "PLUGGABLE FAN ASSEMBLY" IBM TECHNICAL DISCLOSURE BULLETIN, IBM CORP. NEW YORK, US, Bd. 32, Nr. 3A, 1. August 1989 (1989-08-01), Seiten 342-343, XP000049444 ISSN: 0018-8689

## Beschreibung

### Technisches Gebiet

Die Erfindung betrifft einen Lüfter eines elektronischen Gerätes und dessen Befestigung gemäß den Merkmalen des Oberbegriffes des Patentanspruches 1.

### Stand der Technik

Es ist bekannt, einen Lüfter eines elektronischen Gerätes zur Wärmeabfuhr für wärmeerzeugende Bauteile des elektronischen Gerätes über Gummimittel an einem Gehäuse des elektronischen Gerätes zu befestigen. Diese Befestigungsmöglichkeit lässt sich zwar sehr schnell realisieren, hat aber den Nachteil, dass die Gumminippel nicht dauerhaltbar sind, insbesondere wenn sie rauen Umgebungsbedingungen wie Temperaturschwankungen und Vibrationen ausgesetzt sind. Auf Grund einer Materialermüdung kann es zu einem Brechen der Gumminippel kommen, so dass der Lüfter sich von dem Gehäuse löst und auf die Bauteile des elektronischen Gerätes fallen und dort Schaden anrichten kann.

Zur Vermeidung dieser Nachteile ist in der DE 203 20 535 schon vorgeschlagen worden, den Lüfter, genauer dessen Lüftergehäuse, mit einer Klebeschicht zu versehen und an dem Gehäuse des elektronischen Gerätes festzukleben. Diese Befestigungsmöglichkeit hat sich zwar in der Praxis bewährt, ist jedoch auf Grund einer Vielzahl von Montageschritten nachteilig. So muss zunächst das Lüftergehäuse mit einem doppelseitigen Klebeband versehen werden. Anschließend wird der Lüfter auf einer Montagevorrichtung lagerichtig positioniert und anschließend die Schutzfolie des doppelseitigen Klebebandes entfernt. Danach ist es erforderlich, dass das Gehäuse des elektronischen Gerätes lagerichtig zu dem in der Montagevorrichtung platzierten Lüfter ausgerichtet wird, um anschließend unter Druckerzeugung den Lüfter an dem Gehäuse des elektronischen Gerätes festzukleben. Anschließend ist es noch erforderlich, dass der elektrische Antrieb des Lüfters, der mit einem Kabel versehen ist, mit einer Stromversorgung und gegebenenfalls mit einer Steuereinheit zur Regelung des Lüfters verbunden wird. Die Befestigung des Lüfters an dem Gehäuse hat zudem den Nachteil, dass die konstruktiven Gestaltungsmöglichkeiten des gesamten elektronischen Gerätes eingeschränkt sind, da zwecks Erzielung einer optimalen Wärmeabfuhr der Lüfter in dem Bereich angeordnet werden muss, in dem die wärmeerzeugenden Bauteile des elektronischen Gerätes sitzen.

Aus der DE 101 01 348 A1 oder der EP 1 392 095 A1 ist jeweils ein Lüfter eines elektronischen Gerätes zur Wärmeabfuhr für wärmeerzeugende Bauteile des elektronischen Gerätes bekannt, das eine Leiterplatte mit den Bauteilen aufweist, wobei die Leiterplatte in einem Gehäuse des elektronischen Gerätes angeordnet ist, wobei der Lüfter ein Lüftergehäuse aufweiset, wobei das Lüftergehäuse Rastmittel aufweist, mit denen das Lüftergehäuse an dem Gehäuse oder an der Leiterplatte des elektronischen Gerätes festlegbar ist.

Aus der gattungsbildenden DE 197 31 411 A1 ist schließlich ein Lüfter eines elektronischen Gerätes zur Wärmeabfuhr für wärmeerzeugende Bauteile des elektronischen Gerätes bekannt, das eine Leiterplatte mit den Bauteilen aufweist, wobei die Leiterplatte in einem Gehäuse des elektronischen Gerätes angeordnet ist, wobei der Lüfter ein Lüftergehäuse aufweist, wobei das Lüftergehäuse Rastmittel aufweist, mit denen das Lüftergehäuse an dem Gehäuse oder an der Leiterplatte des elektronischen Gerätes festlegbar ist, und wobei das Lüftergehäuse und die Rastmittel einstückig aus Kunststoff ausgebildet sind.

### Darstellung der Erfindung

Der Erfindung liegt daher die Aufgabe zu Grunde, einen Lüfter eines elektronischen Gerätes zur Wärmeabfuhr für wärmeerzeugende Bauteile des elektronischen Gerätes und seine Befestigung anzugeben, mit dem die eingangs geschilderten Nachteile vermieden werden. Insbesondere soll der Befestigungsvorgang erleichtert werden unter Beibehaltung der erforderlichen Wärmeabfuhr während des Betriebes des elektronischen Gerätes.

Diese Aufgabe ist durch die Merkmale des Patentanspruches 1 gelöst.

Erfindungsgemäß ist vorgesehen, dass in den Rastmitteln Kontaktmittel integriert sind, mit denen der Lüfter gleichzeitig mit der Festlegung an der Leiterplatte elektrisch mit dem elektronischen Gerät kontaktiert wird. Dadurch können Kabelbäume, die aus dem Lüfter herausgeführt sind, entfallen und die elektrische Kontaktierung weiter vereinfacht werden, da ein zusätzlicher Arbeitsschritt entfällt.

Ausgangspunkt der Erfindung ist, dass der Lüfter ein Lüftergehäuse aufweist, wobei das Lüftergehäuse Rastmittel aufweist, mit denen das Lüftergehäuse an der Leiterplatte oder dem Gehäuse des elektronischen Gerätes festlegbar ist. Dadurch kann in vorteilhafter Weise das Lüftergehäuse den konstruktiven Gegebenheiten des elektronischen Gerätes optimal angepasst werden, vor allen Dingen kann der Lüfter an einer Stelle innerhalb eines Gehäuses des elektronischen Gerätes positioniert werden, in der er eine bestmögliche Wärmeabfuhr erzielt. Hierzu ist weiterhin vorgesehen, dass das Lüftergehäuse nicht mehr, wie bisher, an dem Gehäuse, sondern an der Leiterplatte des elektronischen Gerätes festlegbar ist. Dadurch kann der Lüfter auf der Leiterplatte an derjenigen Stelle angeordnet werden, an der die wärmeerzeugenden Bauteile sitzen. Dadurch erhöhen sich die konstruktiven Freiheiten beim Design des Gehäuses des elektronischen Gerätes, das dies nur an beliebiger Stelle mit Öffnungen zur Wärmeabfuhr und/oder Ansaugung von Kühlerumgebungsluft versehen werden muss. Zusätzlich ermöglichen die Rastmittel eine schnelle, aber gleichzeitig sichere Festlegung des Lüftergehäuses an der Leiterplatte, so dass dadurch auch die Montage vereinfacht wird. Je nach Ausgestaltung der Rastmittel kann die Leiterplatte hierzu korrespondierend ausgebildet sein (z.B. zur Aufnahme von Rasthaken entsprechende Öffnungen aufweisen), oder aber auch unverändert verbleiben, beispielsweise dann, wenn die Rastmittel als Federlaschen ausgebildet sind und das Lüftergehäuse damit am Rand der Leiterplatte rastend an dieser festgelegt wird.

In Weiterbildung der Erfindung sind die Rastmittel als zumindest ein festes Rastelement und zumindest ein federndes Rastelement ausgebildet. Damit kann das Lüftergehäuse schnell und einfach geführt und lagerichtig in eine Ausnehmung der Leiterplatte eingeführt und festgesetzt werden. Das zumindest eine federnde Rastelement, gegebenenfalls auch mehr als eins, hat dabei die Wirkung, dass das Lüftergehäuse unter einer Vorspannung an der Leiterplatte festgelegt ist, so dass dadurch Toleranzen und vor allen Dingen Vibrationen im Betrieb ausgeglichen werden.

### Kurze Beschreibung der Zeichnung

Weitere Ausgestaltungen der Erfindung sind in den Unteransprüchen angegeben, im Folgenden beschrieben und anhand der Figuren erläutert, wobei die Erfindung nicht auf die Ausführungsbeispiele beschränkt ist.

Es zeigen:
- Figur 1: einen Lüfter mit einem Lüftergehäuse,
- Figur 2: eine weitere Ausgestaltung des Lüftergehäuses mit Stegen,
- Figur 3: das Lüftergehäuse mit Rastmitteln, die als angeformte Laschen ausgebildet sind,
- Figur 4: ein Lüftergehäuse, das über einen als Rahmen ausgebildetes Rastmittel an der Leiterplatte festlegbar ist,
- Figur 5: Kontaktmittel, die zur Stromversorgung des Lüfters in den Rastmitteln integriert sind,
- Figuren 6 bis 9: weitere Ausgestaltungen der Rast- und Kontaktierungsmittel zur Festlegung und gleichzeitigen Kontaktierung des Lüfters bzw. des Lüftergehäuses.

### Wege zur Ausführung der Erfindung

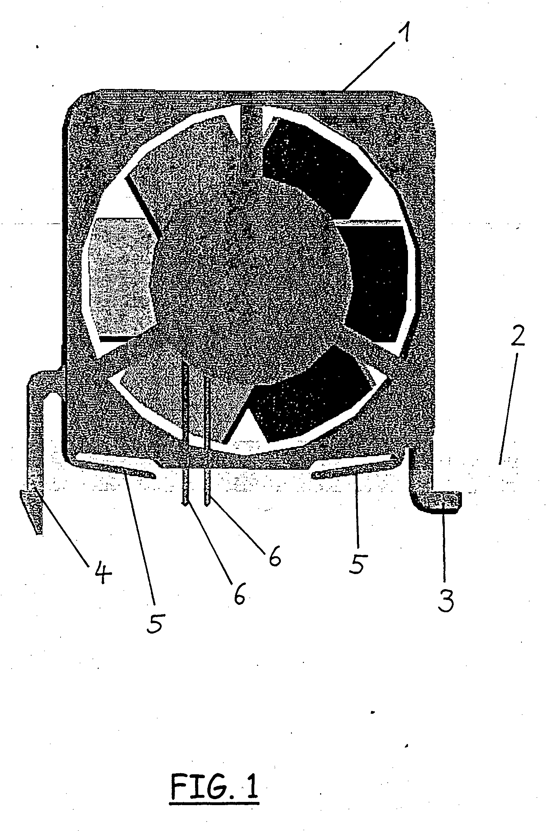

Figur 1 sowie die folgende dazugehörende Beschreibung zeigt, soweit im Einzelnen dargestellt, ein Ausführungsbeispiel, das dem Stand der Technik entspricht, aufweisend einen Lüfter mit einem Lüftergehäuse 1, wobei der Lüfter mit dem Lüftergehäuse 1 an einer Leiterplatte 2 eines nicht dargestellten elektronischen Gerätes festgelegt ist. Bei dem elektronischen Gerät handelt es sich vorzugsweise um ein elektronisches Gerät eines Fahrzeuges, insbesondere eines Kommunikationsgerätes wie ein Antennenverstärker, ein Radio- oder Fernsehempfangsgerät (TV-Tuner) oder dergleichen. Das Lüftergehäuse 1 weist Rastmittel auf, die als festes Rastelelement 3 und als federndes Rastelement 4 ausgebildet sind. Lüftergehäuse 1 und Rastelemente 3, 4 sind einstückig ausgebildet und werden z.B. in einem Kunststoffspritzgussverfahren hergestellt. Die Leiterplatte weist mit den Rastelementen 3, 4 korrespondierende Ausnehmungen auf, wobei das Lüftergehäuse 1 in eine erste Ausnehmung mit dem festen Rastelement 3 schräg eingesetzt wird und dann durch eine Schwenkbewegung das Lüftergehäuse 1 mit einer seiner Seiten planparallel zu der Leiterplatte 2 ausgerichtet wird, wobei das federnde Rastelement 4 in eine korrespondierende Ausnehmung in der Leiterplatte 2 eingreift und auf Grund seines hakenförmigen Endbereiches diese hintergreift und damit das Lüftergehäuse 1 an der Leiterplatte 2 festlegt. Dabei ist es möglich, dass diejenige Stirnseite des Lüftergehäuses 1, die in Richtung der Leiterplatte 2 gewandt ist, dort aufliegt oder auf Distanz angeordnet ist, wozu Anschläge und/oder Federelemente 5 zwecks Toleranzausgleich bzw. zwecks Minimierung von Vibrationsgeräuschen vorgesehen sind. Diese Federelemente 5 können auch dann vorgesehen werden, wenn die Stirnseite des Lüftergehäuses 1 nahezu vollständig auf der Leiterplatte 2 aufliegt. Alternativ zu den Federelementen 5, die ebenfalls einstückig aus dem Lüftergehäuse 1 herausragen, können auch andere Elemente zwecks Toleranzausgleich bzw. Reduzierung von Vibrationsgeräuschen vorgesehen werden. Hier kommt insbesondere auch eine elastisch verformbare Schicht in Betracht. Weiterhin sind noch Kontaktelemente 6 vorhanden, die als starre oder flexible Leiter, z.B. Drähte oder Litzen, ausgeführt sind und bis auf die Leiterplatte 2 reichen, um dort elektrisch kontaktiert, insbesondere verlötet, zu werden.

Die Befestigung des Lüftergehäuses an der Leiterplatte 2 über die Rastmittel 2 hat den Vorteil, dass der Lüfter einfach und schnell lagerichtig positioniert wird und auch im Defektfalle austauschbar ist, was bei einer Befestigung des Lüfters über Gumminippel oder eine Verklebung an dem Gehäuse des elektronischen Gerätes nicht oder nicht ohne Weiteres möglich ist.

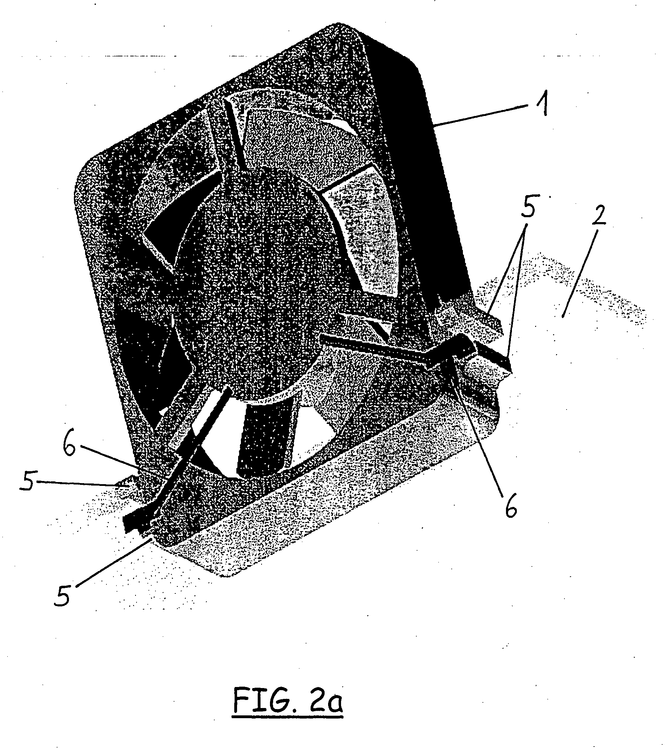

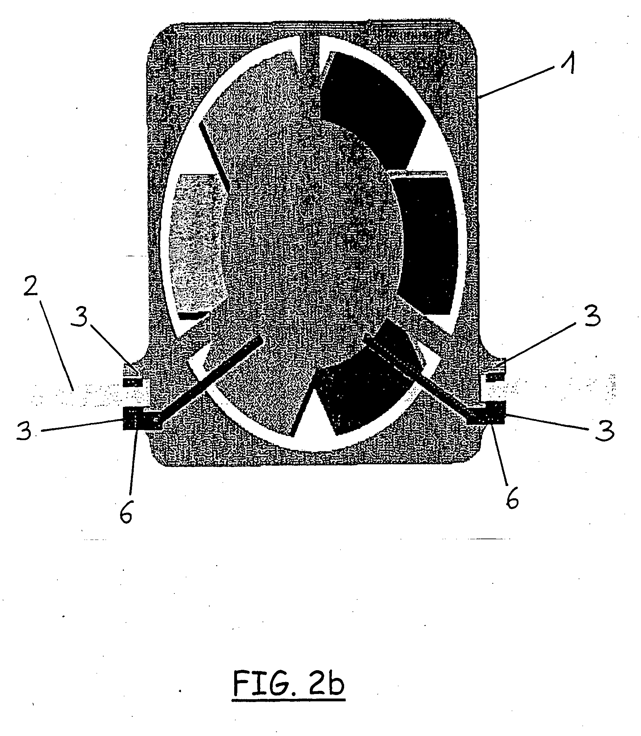

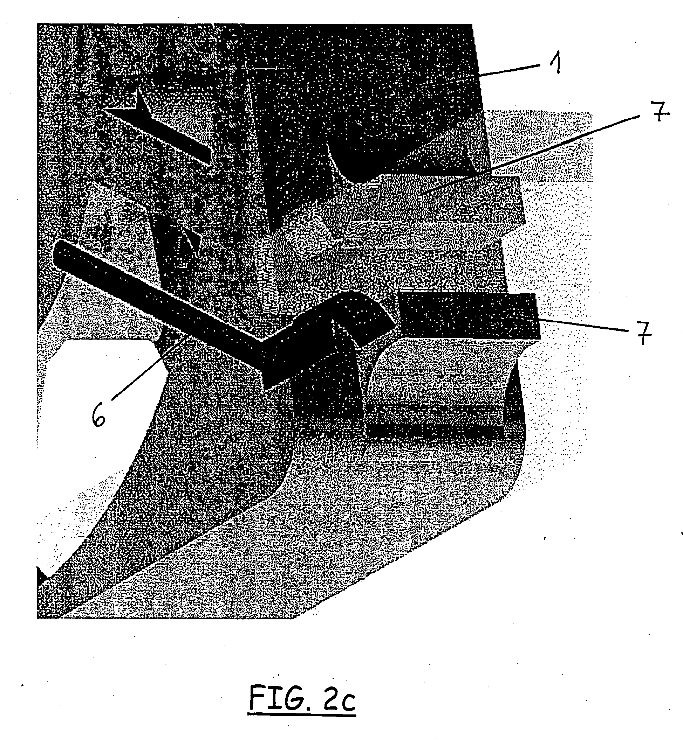

Figur 2, insbesondere Figur 2a, zeigt eine weitere Ausgestaltung des Lüftergehäuses mit Stegen. Neben den schon in der vorangegangenen Figur gezeigten und mit den gleichen Bezugsziffern versehenen Elementen weist das Lüftergehäuse 1 gemäß Figur 2 als Rastmittel zwei parallel zueinander verlaufende Stege 7 auf, die einen Zwischenraum (Schlitz) zwischen den Stegen 7 bilden, um dort die Leiterplatte 2 aufzunehmen. Dabei sind verschiedene Variationen denkbar. Jeweils zwei zueinander parallel verlaufende Stege sind rechts und links von dem Lüftergehäuse 1 vorgesehen und einstückig mit diesem hergestellt und bestehen aus einem elektrisch nicht leitfähigen Material. Diese dienen dann als Rastmittel der Festlegung des Lüftergehäuses 1 an der Leiterplatte 2. Alternativ oder ergänzend dazu ist es möglich, dass einer der Stege 7 elektrisch leitfähig ausgebildet ist und damit einen elektrischen Anschluss für den Antrieb des Lüfters bildet, indem er mit einer Leiterbahn der Leiterplatte 2 zwecks Stromversorgung kontaktiert wird. Bei dem Ausführungsbeispiel gemäß Figur 2b sind die oberhalb der Leiterplatte 2 vorhandenen Stege 7 elektrisch nicht leitfähig und Bestandteil des Lüftergehäuses 1, während die beiden unteren Stege 7 gleichzeitig die Kontaktelemente 6 darstellen, die entweder an dem Lüftergehäuse 1 angeordnet sind oder einstückig mit diesem hergestellt werden und z.B. nachträglich mit einer elektrisch leitfähigen Schicht beschichtet worden sind. Figur 2c zeigt, dass der untere Steg 7 sowohl Rastfunktion als auch Kontaktfunktion übemimmt.

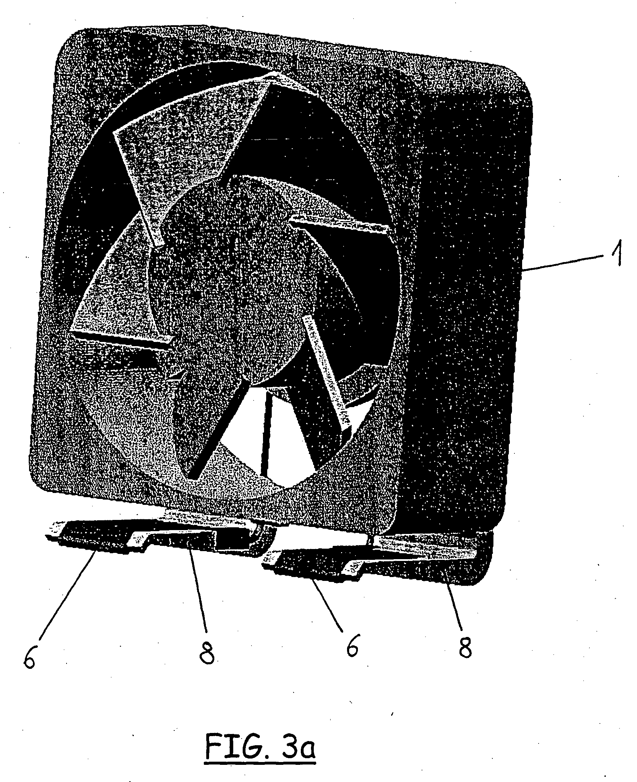

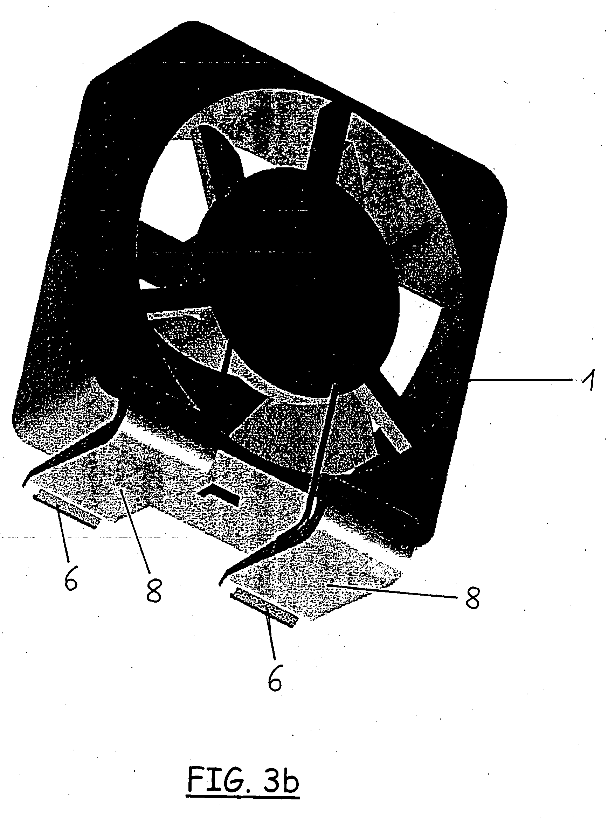

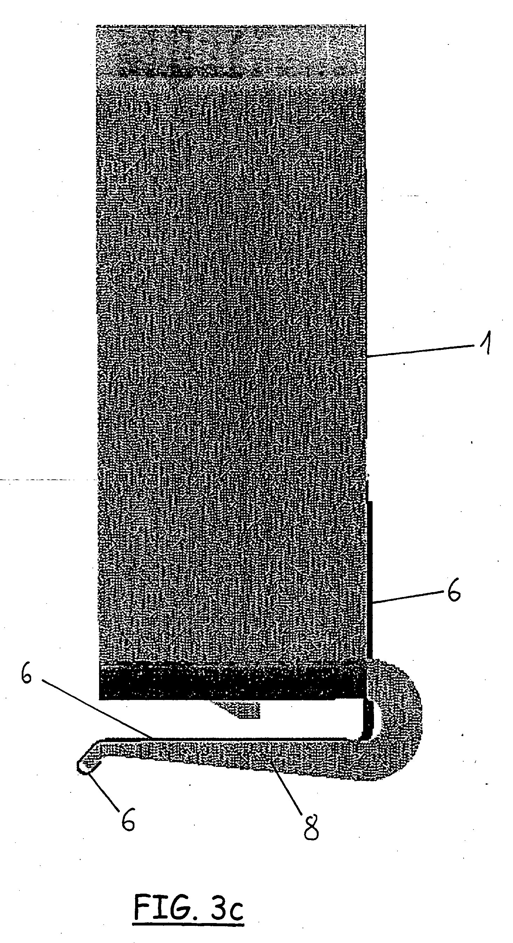

Figur 3a zeigt das Lüftergehäuse 1 mit Rastmitteln, die als angeformte Laschen 8 ausgebildet sind. Diese im Querschnitt U-förmigen Laschen sind entweder einstückiger Bestandteil des Lüftergehäuses 1 und werden bei dessen Herstellung mit angeformt oder sind zusätzliche Rastmittel, mit denen das Lüftergehäuse 1 an der Leiterplatte 2 rastend festgelegt wird. Zu diesem Zweck wird das Lüftergehäuse 1 auf der Leiterplatte 2, insbesondere an deren Rand, aufgesetzt und die separaten Laschen 8 über beide übergeschoben, so dass die rastende Festlegung erfolgt. Auch hier ist es wieder denkbar, dass die als Laschen 8 ausgeführten Rastmittel die Kontaktmittel für die Stromversorgung des Lüfters aufweisen, wobei dies in Figur 3b und c gezeigt ist. Hier sind flächige Kontaktmittel 6 an den Laschen 8 vorhanden, die entsprechende Kontaktflächen an der Unterseite der Leiterplatte 2 kontaktieren, wenn das Lüftergehäuse 1 über den Rand der Leiterplatte 2 übergeschoben und verrastet worden ist.

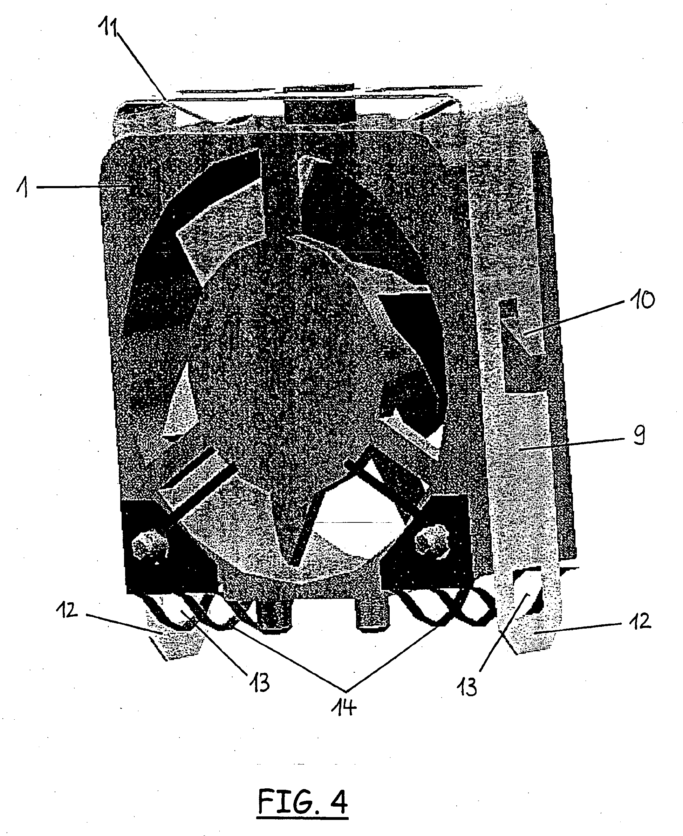

Figur 4 zeigt ein Lüftergehäuse 1, das über einen als Rahmen ausgebildetes Rastmittel an der Leiterplatte 2 festlegbar ist. Ein mit der Bezugsziffer 9 versehener Rahmen umspannt die drei Stirnseiten des Lüftergehäuses 1, die nicht auf der Leiterplatte 2 aufliegen. Über eine Rastnase 10 des Lüftergehäuses 1 wird der mit einer entsprechenden Öffnung versehene Rahmen 9 an dem Lüftergehäuse 1 festgelegt. Zur Erzielung einer Vorspannung ist an der oberen Stirnseite des Rahmens 9 ein Federbereich vorgesehen. Ein laschenartiger Endbereich 12 mit einer Ausnehmung 13 wird der Rahmen 9 in korrespondierende Öffnungen der Leiterplatte 2 eingesetzt und dort rastend festgelegt. Dabei korrespondiert die Ausnehmung 13 des Rahmens 9 mit entsprechenden Rasthaken, Laschen oder dergleichen in der Leiterplatte 2 (oder umgekehrt). Zur Stromversorgung des Lüftermotors sind Kontaktfedern 14 vorgesehen, die z.B. rastend an dem Lüftergehäuse 1 befestigt werden. Diese Kontaktfedern 14 sind vorzugsweise lamellenartig ausgebildet, um nicht beschädigt zu werden und die nötige Druckkraft auf korrespondierende Kontaktflächen auf der Leiterplatte 2 zu erzeugen, nachdem das Lüftergehäuse 1 mit dem Rahmen 9 auf der Leiterplatte 2 festgelegt worden ist.

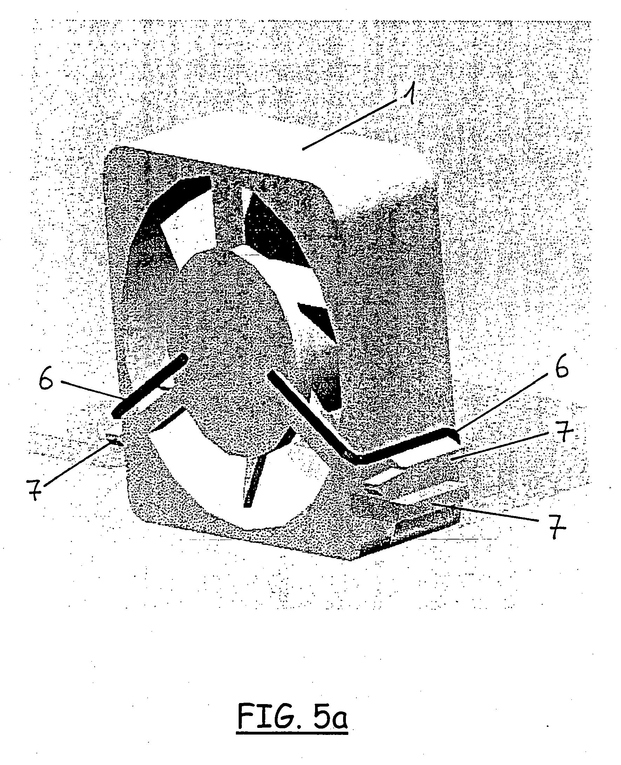

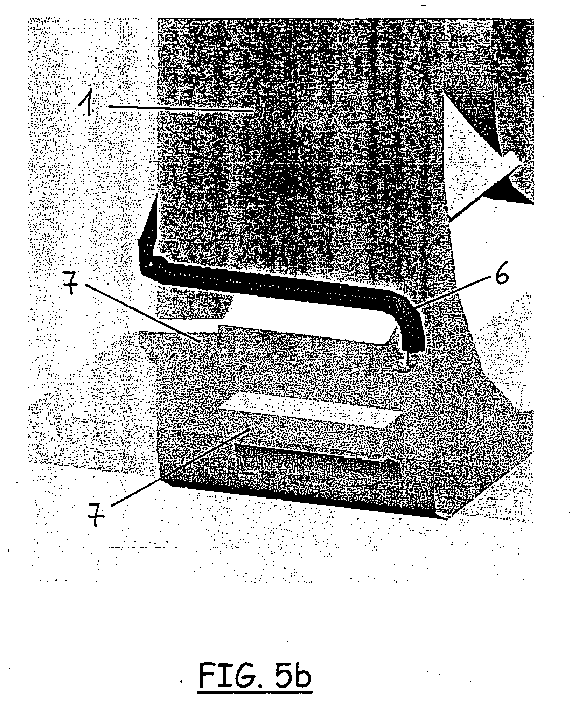

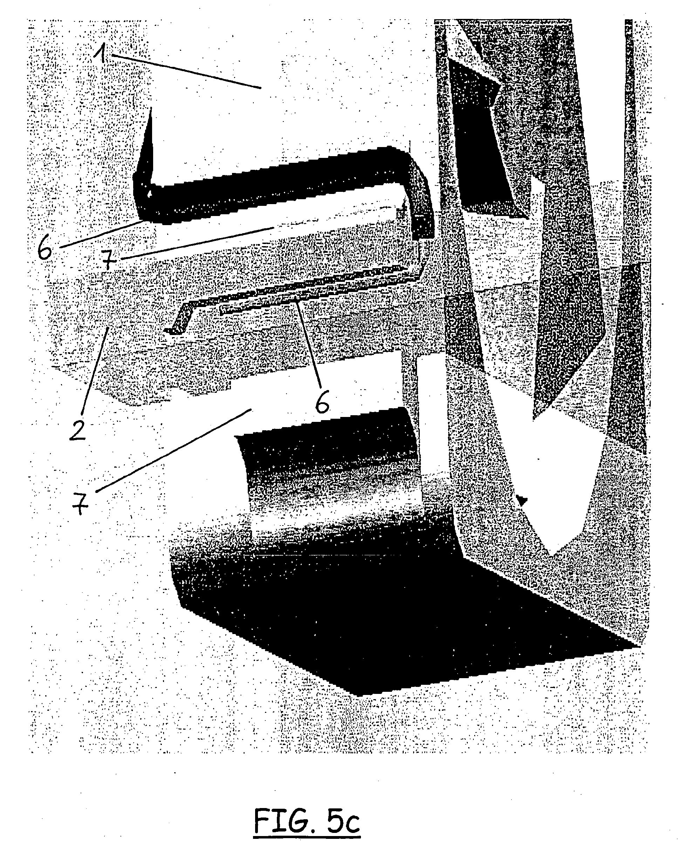

Figur 5a und b zeigt, dass die Kontaktmittel zur Stromversorgung des Lüfters in den Rastmitteln integriert sind. Hierzu sind die Rastmittel wieder als zwei parallele Stege 7 ausgebildet, mit denen das Lüftergehäuse 1 an der Leiterplatte 2 festlegbar ist. Kontaktelemente 6 des Lüftermotors, insbesondere eine abisolierte Litze, werden so um zumindest einen Steg 7 herum angeordnet, dass dieser Steg 7 zusammen mit dem gegenüberliegenden Steg das Ende der Litze auf eine korrespondierende Kontaktfläche der Leiterplatte 2 drückt und somit gleichzeitig mit der Festlegung des Lüftergehäuses 1 auf oder an der Leiterplatte 2 die elektrische Kontaktierung hergestellt ist (Figur 5c). Zu diesem Zweck können an oder in dem Steg 7 noch Aufnahmeräume vorgesehen werden, in denen die Kontaktmittel 6, insbesondere die abisolierte Litze, eingelegt werden und damit fixiert ist, wenn das Lüftergehäuse 1 montiert wird.

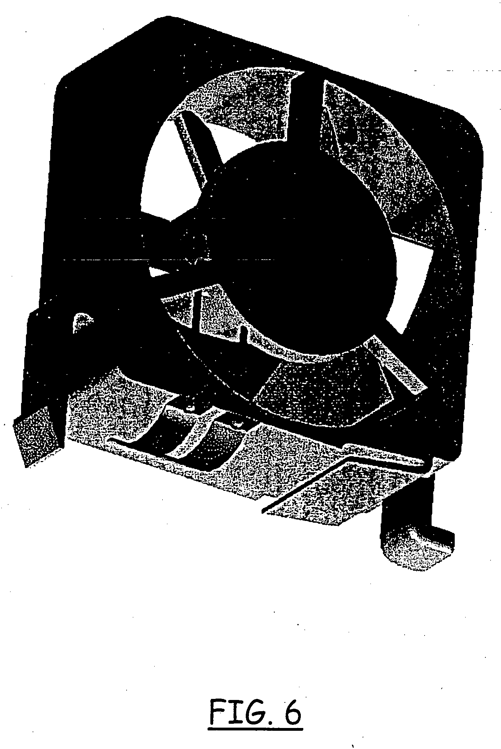

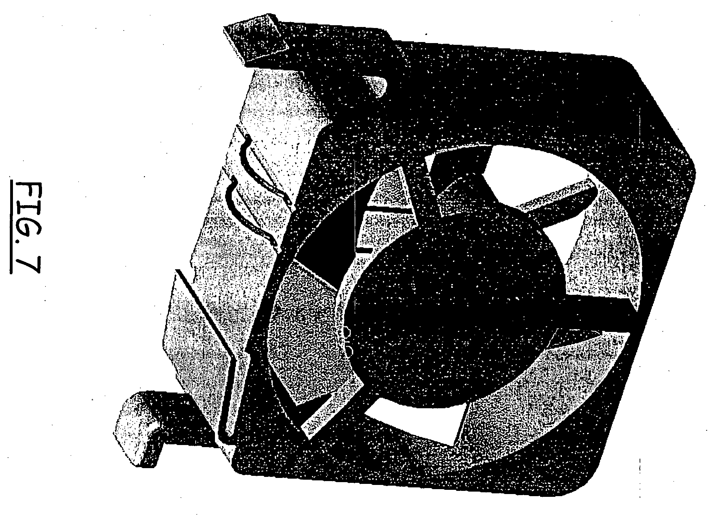

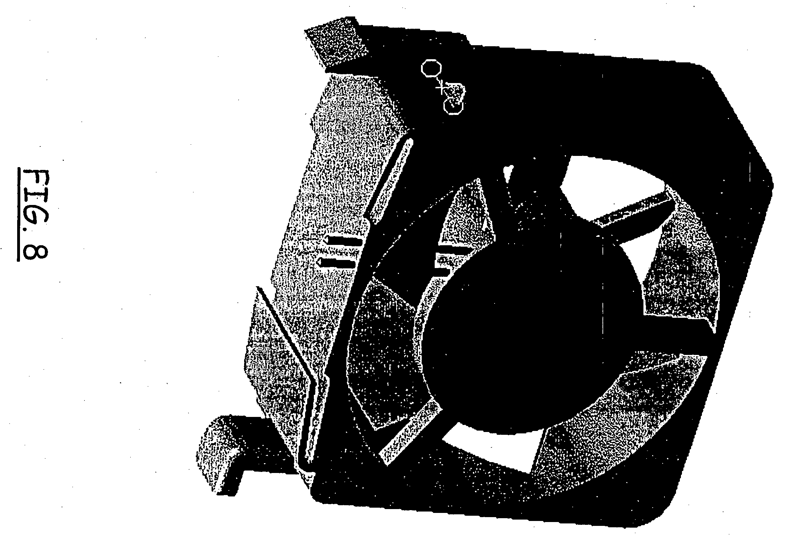

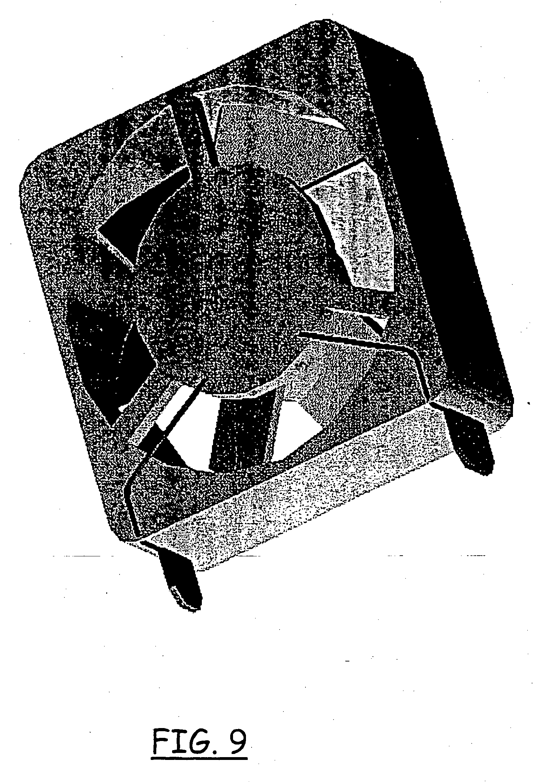

Die Figuren 6 bis 9 zeigen weitere Ausgestaltungen der Rast- und Kontaktierungsmittel zur Festlegung und gleichzeitigen Kontaktierung des Lüfters bzw. des Lüftergehäuses an dem Gehäuse oder der Leiterplatte des elektronischen Gerätes.

### Bezugszeichenliste:

- 1.: Lüftergehäuse
- 2.: Leiterplatte
- 3.: Rastelement
- 4.: federndes Rastelement
- 5.: Feder
- 6.: Kontaktelement
- 7.: Steg
- 8.: Lasche
- 9.: Rahmen
- 10.: Rastnase
- 11.: Federbereich
- 12.: Endbereich
- 13.: Ausnehmung
- 14.: Kontaktfeder

## Patentansprüche

1. Lüfter eines elektronischen Gerätes zur Wärmeabfuhr für wärmeerzeugende Bauteile des elektronischen Gerätes, das eine Leiterplatte (2) mit den Bauteilen aufweist, wobei die Leiterplatte (2) in einem Gehäuse des elektronischen Gerätes angeordnet ist, wobei der Lüfter ein Lüftergehäuse (1) aufweist, wobei das Lüftergehäuse (1) Rastmittel aufweist, mit denen das Lüftergehäuse (1) an dem Gehäuse oder an der Leiterplatte (2) des elektronischen Gerätes festlegbar ist, und wobei das Lüftergehäuse (1) und die Rastmittel einstückig aus Kunststoff ausgebildet sind, **dadurch gekennzeichnet, dass** in den Rastmitteln Kontaktmittel (6) integriert sind, mit denen der Lüfter gleichzeitig mit der Festlegung an der Leiterplatte (2) elektrisch mit dem elektronischen Gerät kontaktiert wird.

2. Lüfter nach Anspruch 1, **dadurch gekennzeichnet, dass** die Rastmittel als zumindest ein festes Rastelement (3) und zumindest ein federndes Rastelement (4) ausgebildet sind.

3. Lüfter nach Anspruch 1 oder 2, **dadurch gekennzeichnet, dass** die Rastmittel als parallel zueinander verlaufende Stege (7) ausgebildet sind, wobei in dem Zwischenraum zwischen den Stegen (7) die Leiterplatte (2) angeordnet ist.

4. Lüfter nach einem der vorhergehenden Ansprüche, **dadurch gekennzeichnet, dass** die Rastmittel als zumindest ein Rastelement (3) und zumindest ein Kontaktelement (6) ausgebildet sind.

5. Lüfter nach einem der vorhergehenden Ansprüche, **dadurch gekennzeichnet, dass** die Rastmittel als Laschen (9) ausgebildet sind.

6. Lüfter nach Anspruch 5, **dadurch gekennzeichnet, dass** die Laschen (9) als separate Bauteile und/oder als vom Lüftergehäuse (1) abstehend und einstückig mit diesem hergestellt ausgebildet sind.

7. Lüfter nach Anspruch 5 oder 6, **dadurch gekennzeichnet, dass** die Laschen (9) mit Kontaktmitteln versehen sind.

8. Lüfter nach einem der vorhergehenden Ansprüche, **dadurch gekennzeichnet, dass** die Kontaktmittel als Kontaktfedern und insbesondere als lamellenartige Kontaktfedern (16) ausgebildet sind.

9. Lüfter nach einem der vorhergehenden Ansprüche, **dadurch gekennzeichnet, dass** das Lüftergehäuse (1) abstehende Federelemente (5) aufweist, die in Richtung der Leiterplatte (2) gerichtet sind.

## Claims

1. Fan of an electronic device for the dissipation of heat for heat-generating components of the electronic device, which has a printed circuit board (2) with the components, wherein the printed circuit board (2) is arranged in a housing of the electronic device, wherein the fan has a fan housing (1), wherein the fan housing (1) has locking means by way of which the fan housing (1) is securable on the housing or on the printed circuit board (2) of the electronic device, and wherein the fan housing (1) and the locking means are realized in one piece from plastics material, **characterized in that** contact means (6), by way of which the fan is contacted in an electrical manner by the electronic device at the same time as the securing on the printed circuit board (2), are incorporated in the locking means.

2. Fan according to Claim 1, **characterized in that** the locking means are realized as at least one fixed locking element (3) and at least one resilient locking element (4).

3. Fan according to Claim 1 or 2, **characterized in that** the locking means are realized as webs (7) which extend parallel to each other, wherein the printed circuit board (2) is arranged in the space between the webs (7).

4. Fan according to one of the preceding claims, **characterized in that** the locking means are realized as at least one locking element (3) and at least one contact element (6).

5. Fan according to one of the preceding claims, **characterized in that** the locking means are realized as lugs (9).

6. Fan according to Claim 5, **characterized in that** the lugs (9) are realized as separate components and/or as components protruding from the fan housing (1) and produced in one piece with said fan housing.

7. Fan according to Claim 5 or 6, **characterized in that** the lugs (9) are provided with contact means.

8. Fan according to one of the preceding claims, **characterized in that** the contact means are realized as contact springs and in particular as lamellar-like contact springs (16).

9. Fan according to one of the preceding claims, **characterized in that** the fan housing (1) has protruding spring elements (5) which are directed in the direction of the printed circuit board (2).

## Revendications

1. Ventilateur destiné à un appareil électronique pour évacuer la chaleur de composants thermogènes de l'appareil électronique, ledit ventilateur comportant une plaque conductrice (2) pourvue des composants, la plaque conductrice (2) étant disposée dans un carter de l'appareil électronique, le ventilateur comportant un carter de ventilateur (1), le carter de ventilateur (1) comportant des moyens d'arrêt permettant de fixer le carter de ventilateur (1) au carter ou à la plaque conductrice (2) de l'appareil électronique et le carter de ventilateur (1) et les moyens d'arrêt étant réalisés d'un seul tenant en matière plastique, **caractérisé en ce que** des moyens de contact (6) à l'aide desquels le ventilateur est placé simultanément en contact électrique avec la fixation à la plaque conductrice (2) et avec l'appareil électronique sont intégrés dans les moyens d'arrêt.

2. Ventilateur selon la revendication 1, **caractérisé en ce que** les moyens d'arrêt prennent la forme d'au moins un élément d'arrêt (3) fixe et d'au moins un élément d'arrêt (4) à ressort.

3. Ventilateur selon la revendication 1 ou 2, **caractérisé en ce que** les moyens d'arrêt prennent la forme d'étais (7) s'étendant parallèlement les uns par rapport aux autres, la plaque conductrice (2) étant disposée dans l'espace intermédiaire situé entre les étais (7).

4. Ventilateur selon l'une quelconque des revendications précédentes, **caractérisé en ce que** les moyens d'arrêt prennent la forme d'au moins un élément d'arrêt (3) et d'au moins un élément de contact (6).

5. Ventilateur selon l'une quelconque des revendications précédentes, **caractérisé en ce que** les moyens d'arrêt prennent la forme de brides (9).

6. Ventilateur selon la revendication 5, **caractérisé en ce que** les brides (9) prennent la forme de composants séparés et/ou sont fabriquées d'un seul tenant avec le carter de ventilateur (1) et ressortent de façon saillante par rapport à lui.

7. Ventilateur selon la revendication 5 ou 6, **caractérisé en ce que** les brides (9) sont pourvues de moyens de contact.

8. Ventilateur selon l'une quelconque des revendications précédentes, **caractérisé en ce que** les moyens de contact prennent la forme de ressorts de contact et notamment de ressorts de contact (16) de type à plaque.

9. Ventilateur selon l'une quelconque des revendications précédentes, **caractérisé en ce que** le carter de ventilateur (1) comporte des éléments de ressort (5) saillants orientés en direction de la plaque conductrice (2).
